Europäisches Patentamt

European Patent Office

Office européen des brevets

(19)

(11) Publication number: **0 106 547
B1**

(12) **EUROPEAN PATENT SPECIFICATION**

(45) Date of publication of patent specification: **17.05.89**

(51) Int. Cl.⁴: **C 30 B 29/26,** C 30 B 13/24

(21) Application number: **83305489.3**

(22) Date of filing: **19.09.83**

(54) **A method of manufacturing an oxide single crystal.**

(30) Priority: **18.09.82 JP 162783/82**

(43) Date of publication of application:
**25.04.84 Bulletin 84/17**

(45) Publication of the grant of the patent:
**17.05.89 Bulletin 89/20**

(84) Designated Contracting States:
**DE FR GB NL**

(56) References cited:
**EP-A-0 018 111
DE-A-2 100 584
GB-A-1 146 967
US-A-3 846 322**

(73) Proprietor: **SONY CORPORATION
7-35 Kitashinagawa 6-Chome Shinagawa-ku
Tokyo 141 (JP)**

(72) Inventor: **Yorizumi, Mineo
c/o Patent Division Sony Corporation
7-35 Kitashinagawa-6 Shinagawa-ku Tokyo (JP)**
Inventor: **Tamura, Hidemasa
c/o Patent Division Sony Corporation
7-35 Kitashinagawa-6 Shinagawa-ku Tokyo (JP)**
Inventor: **Makino, Yoshimi
c/o Patent Division Sony Corporation
7-35 Kitashinagawa-6 Shinagawa-ku Tokyo (JP)**

(74) Representative: **Purvis, William Michael
Cameron et al
D. Young & Co. 10 Staple Inn
London WC1V 7RD (GB)**

Courier Press, Leamington Spa, England.

## Description

The invention relates to a method of manufacturing an oxide single crystal and, more specifically, to a method of growing a single crystal of magnetic oxide material such as ferrite by way of a floating zone process through direct heating.

The floating zone process has heretofor been employed for growing a single crystal and the process has various merits such as avoiding the requirement for a melt crucible, the capability of optionally selecting the crystallographic direction of a grown crystal, homogenizing of the grown crystal by zone levelling and providing a high working efficiency.

Ferrite is a non-stoichiometric compound in which the ratio of the constituent elements cannot be expressed by simple integers and the logarithmic value of the equilibrium oxygen pressure for ferrite in a certain composition varies in proportion to the reciprocal of the temperature for the crystal. As can be seen from the equilibrium oxygen pressure line which is discontinuous at the melting point of ferrite, ferrite releases oxygen gas upon melting.

Accordingly, in the case of growing a single ferrite crystal by way of the floating zone process through direct heating, problems arise if the atmospheric gas employed consists solely of an oxygen gas at a set pressure as is usual.

Patent Specification EP—A—0 018 111 discloses a method of growing ferrite single crystals by melting a starting material in an atmosphere having a total pressure of at least 1 atmosphere and an oxygen partial pressure higher than that in air wherein the crystal is heated by supporting it preferably on a susceptor and inductively heating the susceptor.

Patent Specification DE—A—2 100 584 discloses a method of producing orthoferrite single crystals by the floating zone-melting method from a polycrystalline body in air or an oxygen rich atmosphere having a pressure in the range 1 to 10 atmospheres.

If the concentration of the oxygen gas in the atmospheric gas is excessively high, the oxygen gas released upon melting of the ferrite remains on the surface of a melt-zone as gas bubbles, which disturb the solid-liquid interface or are incorporated in the crystal and seriously degrade the crystallinity.

Further, the temperature of the grown crystal is lowered in the course of growing due to the steep temperature gradient inherent in the floating zone process. Consequently, the oxygen gas pressure in the growing atmosphere goes higher than the equilibrium oxygen pressure as the temperature for the crystal decreases in the course of the growing even if the values for these pressures were equal upon melting of the ferrite. This causes oxidation on the surface of the crystal to deposit $\alpha$-$Fe_2O_3$ and induce cracks in the crystal.

According to the invention there is provided a method of manufacturing an oxide single crystal by way of the floating zone method through direct heating, characterized in that heating is effected in an atmosphere containing 10% to 40% oxygen, the temperature of the crystal (5) during growing is maintained above 1000°C, and the grown crystal (5) is gradually cooled after the completion of growing and after replacing the atmosphere with an inert gas containing less than $10^{-5}$ atmospheres MPa of oxygen.

By use of a method according to the invention the generation of gas bubbles during melting can be suppressed to stabilize a melt-zone and oxidation on the surface of the grown crystal can be prevented.

Advantageously the crystal is ferrite, preferably Mn-Zn ferrite.

The entire pressure of the gaseous mixture is preferably from $10^5$ to $10^7$ Pa (1 to 100 atm) and the temperature of the crystal during growing is preferably maintained above 1200°C.

The invention is diagrammatically illustrated by way of example in the accompanying drawings, in which:—

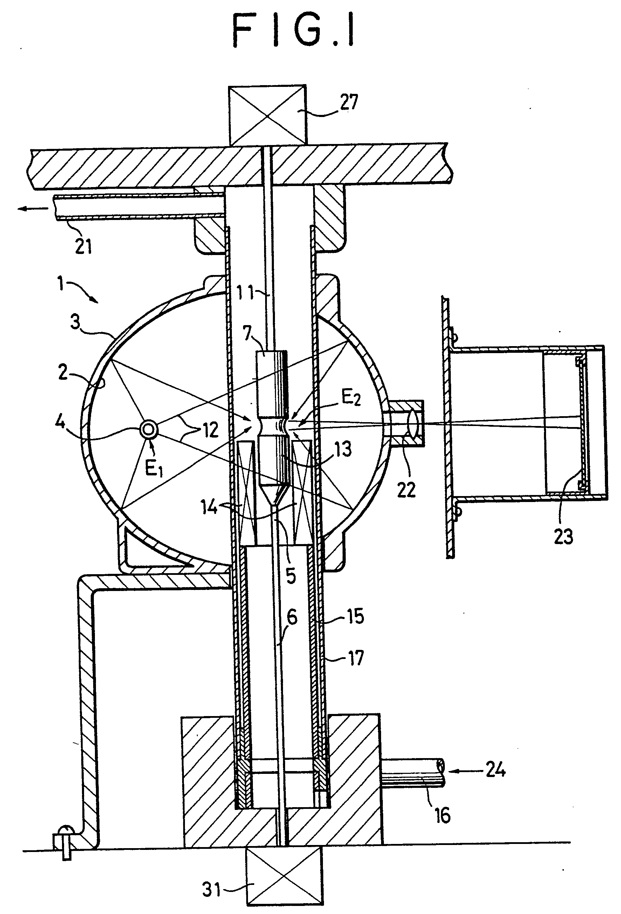

Figure 1 is a schematic vertical cross sectional view of apparatus used for growing a single crystal in accordance with the method of the invention;

Figure 2 is an enlarged vertical cross sectional view of a portion of a polycrystalline ferrite rod and a seed crystal in close contact;

Figure 3 is a vertical cross sectional view, similar to Figure 2, showing the state where a melt-zone is formed;

Figure 4 is a graph showing temperature distribution during growing of a single crystal;

Figure 5 is a cross sectional view showing a starting material and a sub-heater, corresponding to a portion of Figure 1, and also showing a relationship to the temperature distribution shown in Figure 4;

Figure 6 is a graph showing a relationship between the equilibrium oxygen pressure and the crystal; and

Figure 7 is a graph, similar to Figure 6, showing the deposited state of hematite.

In the growth of a single ferrite crystal by way of the floating zone process, direct heating is applied in apparatus 1 by infrared rays. Thus a specimen is not heated indirectly by heat conduction from another heat generating body to the specimen but the specimen is heated directly by the absorption of infrared rays emitted from an infrared source to generate heat by itself. The apparatus 1 comprises an infrared heating chamber 3 having an inner wall surface 2 formed as a rotational ellipsoidally curved plane. The inner wall surface 2 of the infrared heating chamber 3 is formed as a rotational elliptic mirror by gold plating, and a halogen lamp 4 is situated as an infrared source at one focal point $E_1$ of the rotational ellipse. Within the infrared heating chamber 3, are journalled a shaft 6 capable of vertical and rotational movements having a seed crystal 5 made of a single ferrite crystal at the upper end thereof and a shaft 11 also capable of vertical and rotational movements having a polycrystalline rod 7 as a starting material at the lower end thereof, such that both of the shafts pass through the other focal point $E_2$ of the rotational ellipse. In such a structure, infrared rays 12 emitted from the halogen lamp 4 are reflected on the inner wall surface 2 and concentrated at the other focal point $E_2$ locally to heat the polycrystalline ferrite rod 7 situated at the focal point $E_2$. The thus heated polycrystalline ferrite rod 7 is melted from the lower end and succesively grown into a single ferrite crystal 13, which is gradually cooled while being transferred downwardly within a cylindrical sub-heater 14 disposed below the focal point $E_2$. The sub-heater 14 is secured at its lower end to an aluminum cylinder 15 which receives the shaft 6. The cylinder 15 is connected at its lower end to a feed pipe 16 for introducing an atmospheric gas as described below. Furthermore, a quartz tube 17 is disposed substantially vertically around the shaft 11, the sub-heater 14 and the cylinder 15, and the inside of the quartz tube 17 is filled with a predetermined atmospheric gas for the crystal growth. The atmospheric gas is supplied from the feed pipe 16 at the lower end of the apparatus and discharged through an exhaust pipe 21 at the upper end of the apparatus. The growing state of the crystal is projected by way of a lens 22 and displayed on a screen 23.

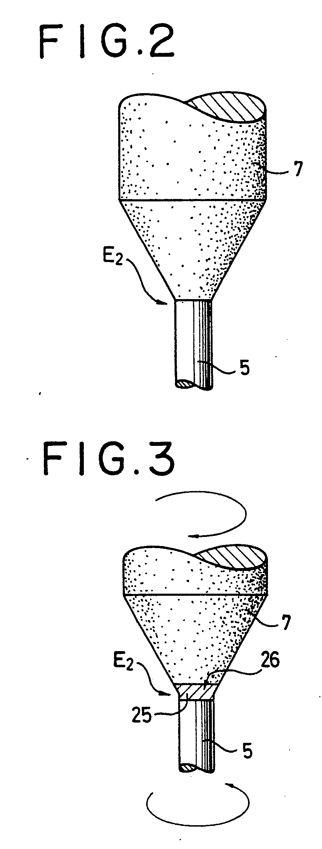

The method of operating the apparatus 1 will now be explained. As shown in Figure 2, the polycrystalline ferrite rod 7 and the seed crystal 5 are at first situated fixedly in close contact with each other at the position of the focal point $E_2$. Then, a gaseous mixture 24 containing oxygen at a predetermined concentration is introduced through the feed pipe 16 into the quartz tube 17 to establish a predetermined pressure within the quartz tube 17. Then, the polycrystalline ferrite rod 7 and the seed crystal 5 are rotated by respective motors 27, 31 in opposite directions to each other as shown in Figure 3, and the entire connection area between both of them 25 under infrared heating by the halogen lamp 4 to form a melt-zone 26. By lowering both the polycrystalline ferrite rod 7 and the seed crystal 5 while rotating them by the motors 27 and 31, the polycrystalline ferrite rod 7 is continuously melted from its lower end upwards and made into a single ferrite crystal by gradual cooling in the sub-heater 14.

It has been found extremely important, upon growing the single crystal ferrite 13, carefully to control the composition of the atmospheric gas for the crystal growth, in order to prevent the generation of oxygen gas bubbles in the melt-zone 26.

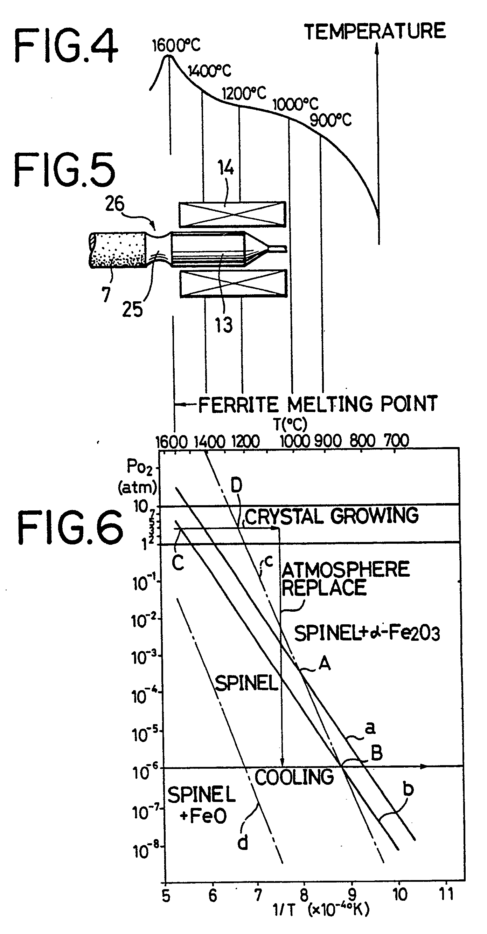

Figure 6 shows a relationship between the equilibrium oxygen pressure $PO_2$ and the crystal temperature T for Mn-Zn ferrite in the floating zone process. In Figure 6 a solid line $a$ represents the equilibrium oxygen pressure line for ferrite having a composition consisting of 50 mol% $Fe_2O_3$, 20 mol% ZnO and 30 mol% MnO, while a solid line $b$ represents the equilibrium oxygen pressure line for ferrite having a composition consisting of 55 mol% $Fe_2O_3$, 20 mol% ZnO and 25 mol% MnO. A dotted line $c$ represents an upper limit for the region where a stable spinel phase, i.e., composed only of ferrite is present, while a dotted line $d$ represents the lower limit therefor. These lines in the figure are approximately expressed by the following equations.

a: $\log Po_2(\text{atm}) = 11.4 - 1.86 \times 10^4 / T(°K)$
b: $\log Po_2(\text{atm}) = 10.6 - 1.86 \times 10^4 / T(°K)$
c: $\log Po_2(\text{atm}) = 19.8 - 2.91 \times 10^4 / T(°K)$
d: $\log Po_2(\text{atm}) = 15.3 - 3.15 \times 10^4 / T(°K)$

While a stable spinel phase is present in the region between the two limiting lines, $\alpha$-$Fe_2O_3$ (hematite) phase is deposited in the region above the limiting line $c$ and FeO (wustite) phase is deposited in the region below the limiting line $d$. Accordingly, this means that the stable spinel phase can no longer be present at a temperature below the crossing points A and B between the limiting line $c$ and the equilibrium oxygen pressure lines $a$ and $b$. However, since the reaction rate is extremely low in the region, no such deposition as causing substantial problem due to $\alpha$-$Fe_2O_3$ results within an actual cooling period of time if the oxygen partial pressure is not greater than $10^{-5}$ atm. Although not illustrated in the graph, the equilibrium oxygen pressure lines $a$ and $b$ are discontinuous at each of the melting points, at which the ferrites release oxygen gas upon melting. Since this causes oxygen bubbles to be generated upon melting of ferrite in the floating process through infrared direct heating, it is necessary to avoid such disadvantages.

In view of the above, the foregoing defects have been overcome in the method according to the present embodiment by introducing a gaseous mixture through the pipe 16 of an oxygen gas and a chemically inert gas (for example Ar) as an atmospheric gas during growing of a single crystal and by setting the concentration of the oxygen in the gaseous mixture to be 10% to 40% as expressed by the oxygen partial pressure. Thus, the generation of oxygen gas bubbles can be prevented by lowering the concentration of oxygen in the atmosphere during melting of ferrite.

Furthermore, the pressure for the growing atmosphere, that is, the total pressure of oxygen pressure and inert gas pressure is, desirably, in a range from an ambient pressure up to 100 atm.

The advantageous effects of the invention will now be detailed referring to an experimental example.

A powderous mixture having a ferrite composition consisting of 53 mol% $Fe_2O_3$, 20 mol% ZnO and 27 mol% MnO was pressed under a pressure of 1 t/cm². Then, the pressed product was moulded into a cylinder of 20 $\phi \times 100$ mm length and sintered at 1400°C for 5 hours in an oxygen gas. Then, the starting rod was closely contacted with and secured to a Mn-Zn ferrite seed crystal within the quartz tube, and the seed crystal was melted through infrared direct heating to form a melt-zone between the starting rod and the seed crystal under the entire pressure of 10 atm within the quartz tube. The starting rod and the seed crystal were rotated each at 30 rpm in directions opposite to each other and both of them were moved downwardly at a rate of 20 mm/hr to grow a single crystal. The molten state of the ferrite under various atmospheric oxygen pressures was as below:

| Oxygen pressure/oxygen +Ar pressure | Molten state of ferrite |
|---|---|
| 100% | × |
| 90% | × |
| 80% | × |
| 70% | × |
| 60% | × |
| 50% | Δ |
| 40% | ○ |
| 30% | ○ |
| 20% | ○ |
| 10% | ○ |
| 0% | Δ |

wherein the symbol "×" represents the generation of gas bubbles in the melt-zone thus failing to obtain single crystal at high quality, the symbol "Δ" represents the possible remaining of gas bubbles in the single crystal or reduction of the oxygen ratio in the single crystal and the symbol "○" represents the formation of a smooth melt-zone enabling a single crystal of high quality to be obtained.

As apparent from the foregoing result, a smooth melt-zone can be prepared thereby to obtain a single crystal stably of high quality by selecting the composition of the atmosphere during growing. Further, since the entire pressure is kept unchanged even if the oxygen pressure is decreased, an easily volatilizing substance such as Zn, if present in the composition of the grown crystal, can be suppressed from volatilization. Furthermore, oxidation on the surface of the crystal can be suppressed thereby to prevent the deposition of α-Fe$_2$O$_3$ on the surface of the crystal during growing.

In the present embodiment, it has also been found to be extremely important that the temperature for the crystal is always maintained above 1000°C, preferably, above 1200°C in the course of growing the single crystal, as well as that the thus grown crystal is gradually cooled to a room temperature after the completion of the growing and after replacing the atmosphere with a chemically inert gas such as Ar or N$_2$ containing such a trace amount of oxygen as: P$_{O2}$≦10$^{-5}$ atm., which will be detailed hereinafter. The replacement of the atmosphere is carried out by discharging the gaseous mixture from the exhaust pipe 21 while supplying the inert gas as described above from the feed pipe 16.

Figures 4, 5 and 6 show the relationship between the temperature for the grown crystal and the equilibrium oxygen pressure in a case where single crystal ferrite is grown by the floating zone process, in conjunction with the temperature distribution from the melt zone to the inside of the sub-heater. Assuming, for example, such a case where the crystal is grown at the equilibrium oxygen pressure: P$_{O2}$=3 atm., since the single crystal is formed at the point C and the temperature for the crystal reduces in the direction of the arrow, a part of the crystal exceeds the upper limiting line c to cause α-Fe$_2$O$_3$ deposition. As a matter of course, also in the case of cooling the crystal after growing, the crystal entirely exceeds the limiting line c with respect to the equilibrium oxygen partial pressure P$_{O2}$ during the growing and the crystal is oxidized (causing deposition of α-Fe$_2$O$_3$). In view of the above, an experiment was conducted for determining the conditions capable of taking out a crystal while suppressing the deposition of α-Fe$_2$O$_3$, in the course of the growing and the cooling, within 1 mm depth from the surface of the crystal, that is, to such an extent as providing no practical problems.

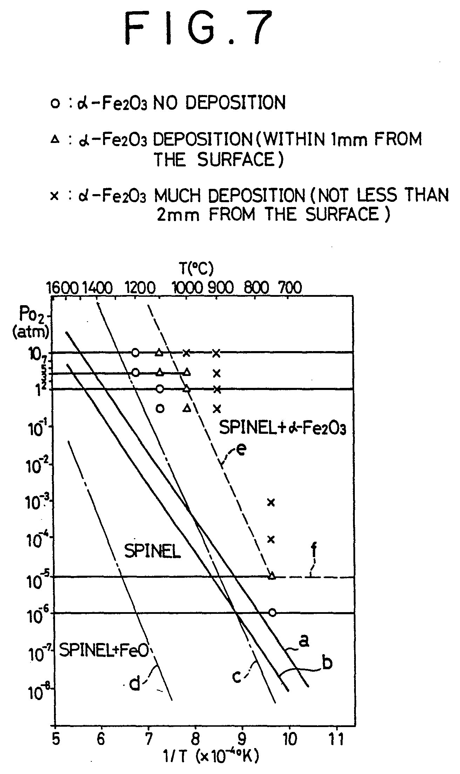

In the growing stage, such conditions can theoretically (in the theory of equilibrium) be attained by maintaining, by the sub-heater, the temperature of the crystal higher than the point D. The extent of oxidation at the crystal surface at a temperature lower than the point D within a practical growing time (5—10 hours) was examined experimentally. In the experiment, crystals were grown under various equilibrium oxygen pressures PO$_2$ (0.5—10 atm), rapidly cooled upon completion of the growing to a predetermined temperature, maintained at the level for a predetermined time and the "depth for the deposited layer of α-Fe$_2$O$_3$" on the crystal surface was examined. Then, the relation between the depth of the deposited layer and the temperature was determined based on the temperature distribution of the crystal previously measured. The result is shown in Figure 7, wherein broken lines e and f represent the upper limit for the region where the membrane deposited on the surface within a practical growing time. In this case, the broken lines e and f are expressed by the following equations:

e: logPo$_2$(atm)=22.8−2.91×10$^4$/T(°K)

f: logPo$_2$(atm)=10$^{-5}$

The limiting line is flat below about 700°C, because the reaction rate is retarded due to the low temperature, at which the effect of an oxidizing atmosphere is negligible. The points for the equilibrium oxygen pressures: 10$^{-3}$, 10$^{-4}$, 10$^{-5}$, 10$^{-6}$ atm at 750°C were determined by mirror-finishing the slices of the ferrite, maintaining the slices at 750°C for one hour and, thereafter, observing the α-Fe$_2$O$_3$ at the surface of them.

As can be seen from the result in Figure 7, the α-Fe$_2$O$_3$ deposition layer in the crystal was at a depth of not less than 2 mm and cracks starting from the deposited layer developed as far as the inside of the crystal thus failing to obtain a crack-free crystal in the region above the limiting lines e and f. In Figure 7, such a defective state is shown by the symbol "×", the state where the α-Fe$_2$O$_3$

deposited later in the depth of within 1 mm is represented by the symbol "Δ" and the state with no deposition of α-$Fe_2O_3$ is represented by the symbol "○". This shows that, in order to obtain a crack-free crystal, the crystal must be maintained at a temperature higher than the limiting line e, that is, above 1000°C, (preferably above 1200°C) during the growing stage and gradually cooled after replacing the atmosphere with an inert gas containing less than $10^{-5}$ atm of oxygen during the cooling stage.

Various modifications are possible within the scope of the appended claims, for instance, other direct heating means than that of the infrared rays may be employed for heating to melt the starting material for the crystal growth. Furthermore, the inert gas to be mixed as the atmospheric gas during growing may consist of one or more inert gases.

As described above, since a gaseous mixture comprising an oxygen gas of 10% to 40% concentration and an inert gas is used as the atmospheric gas during growing of a crystal, it is possible to obtain a crystal of high quality by suppressing the generation of gas bubbles upon melting to stabilize the melt-zone and further prevent the oxidation on the surface of the grown crystal by the reduction of the oxygen pressure. In addition, since the temperature for the crystal during growing is set to above 1000°C and, thereafter, the grown crystal is gradually cooled after replacing the atmospheric gas at least partially with an inert gas, no foreign substance such as hematite is produced on the surface of the crystal, that is, surface oxidation can be prevented thereby effectively to avoid the generation of cracks.

By "atmosphere" throughout the specification is meant a pressure equal to 100,000 Pascals.

## Claims

1. A method of manufacturing an oxide single crystal by way of the floating zone method through direct heating, characterized in that heating is effected in an atmosphere containing 10% to 40% oxygen, the temperature of the crystal (5) during growing is maintained above 1000°C, and the grown crystal (5) is gradually cooled after the completion of growing and after replacing the atmosphere with an inert gas containing less than $10^{-5}$ atmospheres (1 Pa) of oxygen.

2. A method according to claim 1, characterized in that the crystal (5) is ferrite.

3. A method according to claim 2, characterized in that the ferrite is Mn-Zn ferrite.

4. A method according to claim 1, characterized in that the entire pressure of the gaseous mixture is from $10^5$ to $10^7$ Pa (1 to 100 atm).

5. A method according to claim 1, characterized in that the temperature of the crystal (5) during growing is maintained above 1200°C.

## Patentansprüche

1. Verfahren zur Herstellung eines Oxyd-Einkristalls auf dem Weg des tiegelfreien Zonenziehens durch Direkterwärmung, dadurch gekennzeichnet,
—daß die Erwärmung in einer Atmosphäre, die 10 Mol-% bis 40 Mol-% Sauerstoff enthält, bewerkstelligt wird,
—die Temperatur des Kristalls (5) während des Wachstums über 1000°C gehalten wird, und
—der gewachsene Kristall (5) nach Vervollständigung des Wachstums und nach Austausch der Atmosphäre durch ein Inertgas, das weniger als $10^{-5}$ at (1 Pa) Sauerstoff enthält, schrittweise abgekühlt wird.

2. Verfahren gemäß Anspruch 1, dadurch gekennzeichnet, daß der Kristall (5) Ferrit ist.

3. Verfahren gemäß Anspruch 2, dadurch gekennzeichnet, daß das Ferrit ein Mn-Zn-Ferrit ist.

4. Verfahren gemäß Anspruch 1, dadurch gekennzeichnet, daß der Gesamtdruck der Gasmischung von 1 bis 100 at ($10^5$ bis $10^7$ Pa) ist.

5. Verfahren gemäß Anspruch 1, dadurch gekennzeichnet, daß die Temperatur des Kristalls (5) während des Wachstums oberhalb von 1200°C gehalten wird.

## Revendications

1. Un procédé de fabrication d'un monocristal d'oxyde par la méthode à zone flottante par chauffage direct, caractérisé en ce que le chauffage est effectué dans une atmosphère contenant 10% en moles à 40% en moles d'oxygène, la température du cristal (5) durant la croissance est maintenue au-dessus de 1 000°C, et le cristal après croissance (5) est graduellement refroidi après croissance complète et après remplacement de l'atomsphère par un gaz inerte contenant moins de $10^{-5}$ atmosphère (1 Pa) d'oxygène.

2. Un procédé selon la revendication 1, caractérisé en ce que le cristal (5) est du ferrite.

3. Un procédé selon la revendication 2, caractérisé en ce que le ferrite est du ferrite de Mn-Zn.

4. Un procédé selon la revendication 1, caractérisé en ce que la pression totale du mélange gazeux est de 1 à 100 atmosphères ($10^5$ à $10^7$ Pa).

5. Un procédé selon la revendication 1, caractérisé en ce que la température du cristal (5) durant la croissance est maintenue au-dessus de 1 200°C.

# F I G . 1

# F I G . 2

# F I G . 3

# FIG.4

# FIG.5

# FIG.6

TEMPERATURE

1600°C
1400°C
1200°C
1000°C
900°C

FERRITE MELTING POINT

T(°C)
1600 1400 1200 1000 900 800 700

$P_{O_2}$ (atm)

CRYSTAL GROWING

ATMOSPHERE REPLACE

SPINEL+$\alpha$-Fe$_2$O$_3$

SPINEL

COOLING

SPINEL +FeO

$1/T$ ($\times10^{-4}$°K)

# F I G . 7

o : $\alpha$-Fe$_2$O$_3$ NO DEPOSITION

$\triangle$ : $\alpha$-Fe$_2$O$_3$ DEPOSITION (WITHIN 1mm FROM
        THE SURFACE)

x : $\alpha$-Fe$_2$O$_3$ MUCH DEPOSITION (NOT LESS THAN
        2mm FROM THE SURFACE)